(19) Europäisches Patentamt / European Patent Office / Office européen des brevets

(11) **EP 4 675 266 A1**

(12) **EUROPEAN PATENT APPLICATION**

(43) Date of publication:
**07.01.2026 Bulletin 2026/02**

(21) Application number: **24185993.3**

(22) Date of filing: **02.07.2024**

(51) International Patent Classification (IPC):
**G01N 27/04** *(2006.01)*   **G01R 27/14** *(2006.01)*

(52) Cooperative Patent Classification (CPC):
**G01N 27/045; G01R 27/14**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **VOCSens**
**1348 Ottignies-Louvain-la-Neuve (BE)**

(72) Inventors:
• **POLLISSARD, Guillaume Augustin Claude**
  **1380 Lasne (BE)**
• **GONZALEZ VAN NES, Luca Johannes Manuel**
  **1050 Bruxelles (BE)**
• **PÉTRÉ, Sylvain Gilbert Adelin**
  **4287 Racour (BE)**

(74) Representative: **Gevers Patents**
**De Kleetlaan 7A**
**1831 Diegem (BE)**

(54) **APPARATUS AND METHOD FOR DETERMINING THE RESISTANCE VALUE OF A RESISTIVE SENSOR IN A PLURALITY OF RESISTIVE SENSORS**

(57) The invention relates to an apparatus (100) for determining a resistance value of one (102) of a plurality of resistive sensors based on a measure of a current responsive to a bias voltage (107) applied to said one resistive sensor (102), the apparatus (100) comprising: a bias voltage generator (101) for applying a bias voltage (107) to said one resistive sensor (102); a bias voltage controller (103) coupled with said bias voltage generator (101) and configured for adjusting said bias voltage (107) based on a sensing current (108, 109) flowing through said one resistive sensor (102); a current measurement unit (104) configured for measuring a sensing current (108, 112) flowing through said one resistive sensor (102) once said bias voltage (107) has been adjusted; a sensor selection unit (105) coupled with the bias voltage controller (103) and the current measurement unit (104), and configured for selecting a resistive sensor (102) in the plurality of resistive sensors.

100

**FIG. 1**

EP 4 675 266 A1

## Description

## Field of the invention

The present invention relates generally to the field of resistive sensing, and in particular to the field of resistive chemical sensing. The invention proposes an apparatus for determining a resistance value of a resistive sensor in a plurality of resistive sensors, in particular of a resistive gas sensor, and a method for operating the apparatus.

## Background of the invention

Determining the concentration of one or several chemical compounds such as NH3, CO2, CO, NO2, NO, CH4, H2, formaldehyde, BTEX, other volatile organic compounds, or other chemical compounds in general, plays a crucial role in various applications ranging from environmental monitoring to industrial safety. The concentration of one or several of the abovementioned chemical compounds, or other chemical compounds, may be measured using a resistive sensor. A resistive sensor consists of a resistor whose electrical resistance varies with the concentration of a chemical compound. Such a resistor is also called a chemiresistor. Determining a resistance value of a resistive sensor sensitive to a specific chemical compound allows the measurement of the concentration of the chemical compound. In particular, a resistive gas sensor is a resistive sensor that may be used to measure the concentration of a chemical compound in a gaseous state. A resistive gas sensor consists of a resistor whose electrical resistance varies with the concentration of a gas. Determining a resistance value of a resistive sensor sensitive to a specific gas allows the measurement of the concentration of the gas.

In addition, it is desirable to be able to measure the concentration of a plurality of gases with a single device, for instance in a case where some exhaust fumes may contain several gases that may be harmful for the environment or for workers exposed to the fumes. A gas measurement device comprising several gas sensors, each sensor being sensitive to a specific gas, allows the measurement of the concentration of a plurality of gases with a single device.

The electrical resistance of a resistive gas sensor may vary by several orders or magnitudes, typically ranging from a few kiloohms (kΩ) to several hundred megaohms (MΩ), depending on the concentration of a target gas to be measured. In addition, other factors such as sensor fabrication, sensor aging, and the specific target gas to be measured may affect the baseline resistance of a sensor, i.e. the resistance exhibited by the sensor in the absence of a target gas. Indeed, fabrication processes introduce inherent variability among produced sensors, resulting in variations in baseline resistance values among different sensors. Furthermore, the aging of a sensor may cause the baseline resistance of a sensor to change throughout the life of the sensor. Finally, in the case of a device comprising several gas sensors to measure the concentration of a plurality of gases, the baseline resistance of the sensors may vary depending on the sensitive material used in each sensor. Therefore, it is desirable that a system measuring the concentration of one or several gases using one or several resistive gas sensors is able to measure a wide range of resistance values, ranging from a few kiloohms (kΩ) to several hundred megaohms (MΩ).

There exist several known methods to measure an electrical resistance of a resistive sensor, such as the balancing of a Wheatstone bridge, or methods relying on Ohm's Law, such as a current bias method and a voltage bias method. First, a Wheatstone bridge is an electrical circuit used to measure an electrical resistance of a resistor by balancing two legs of a bridge circuit, one leg of which includes the resistor to be measured. Besides, Ohm's Law states that the voltage V across a resistor of resistance R is directly proportional to the current I flowing through the resistor, i.e. $V = R.I$, which allows measuring of the resistance R as $R = V/I$. Measuring a resistance using a current bias method consists in applying a known current to a resistor and observing the resulting voltage across the resistor, then infer the resistance value using Ohm's Law. Reciprocally, measuring a resistance using a voltage bias method consists in applying a known voltage across a resistor and observing the resulting current through the resistor, then infer the resistance value using Ohm's Law.

Document JP08247993A describes an oxygen concentration meter to measure a wide range of oxygen concentration values using an oxygen sensor. The disclosed oxygen concentration meter comprises a sensor made of a solid electrolyte of oxygen ion conductor, a voltage applying unit for applying a voltage to the plate of the sensor, a current detector for detecting a critical current flowing through the sensor, and an applied voltage switching unit for switching the voltage applied to the sensor by the unit to a low voltage for measuring low oxygen concentration or a high voltage for measuring high oxygen concentration. However, the disclosure of JP08247993A is specific to the measurement of oxygen concentration and lacks the ability to measure the concentration of a plurality of gases.

In view of the prior art, there is a need for an apparatus able to measure a wide range of resistance values of a plurality of resistive sensors, in particular of a plurality of resistive gas sensors, in order to determine the concentration of a plurality of gases.

## Summary of the invention

An object of the present invention is to provide an apparatus and a method for operating the apparatus able to determine a wide range of resistance values of a plurality of resistive sensors.

According to a first aspect, the invention provides an apparatus for determining a resistance value of one of a plurality of resistive sensors based on a measure of a current responsive to a bias voltage applied to said one resistive sensor, the apparatus comprising:

- a bias voltage generator for applying a bias voltage to said one resistive sensor;
- a bias voltage controller coupled with said bias voltage generator and configured for adjusting said bias voltage based on a sensing current flowing through said one resistive sensor;
- a current measurement unit configured for measuring a sensing current flowing through said one resistive sensor once said bias voltage has been adjusted;
- a sensor selection unit coupled with the bias voltage controller and the current measurement unit, and configured for selecting a resistive sensor in the plurality of resistive sensors.

The apparatus according to the present invention allows the determination of a resistance value of a resistive sensor by measuring a sensing current flowing through the resistive sensor in response to the application of a bias voltage to the resistive sensor. The bias voltage is applied to the resistive sensor by a bias voltage generator, the bias voltage generator being controlled by a bias voltage controller based on the sensing current flowing through the resistive sensor. Together, the bias voltage controller, the bias voltage generator, and the resistive sensor form a feedback loop allowing the adjustment of the bias voltage applied to the sensor based on the sensing current flowing through the sensor. In addition, the apparatus according to the invention comprises a current measurement unit allowing the measurement of the sensing current flowing through the resistive sensor once the bias voltage has been adjusted. The measure of the sensing current may be used to determine the resistance value R of the resistive sensor using Ohm's Law based on the value of the bias voltage V and the sensing current I as R = V/I.

The control of the bias voltage "based on the sensing current" as used herein means that the bias voltage is controlled, or adjusted, in function of a signal that is the sensing current itself, or that is linked to the sensing current, such as a copy of said sensing current, for instance.

By adjusting the bias voltage, the apparatus according to the invention can measure a wide range of resistance values. Indeed, not all current values can be measured. Current values that are too low may not be detected by a current measurement device, and current values that are too high may saturate a current measurement device. Therefore, only current values being neither too low nor too high can be measured, i.e. current values lying between a minimal limit value I_min and a maximal limit value I_max.

For a given bias voltage, these current limits lead to a limit in the range of measurable resistance values. Since R = V/I, for a given bias voltage V_bias, a minimal current I_min corresponds to a maximal resistance R_max = V_bias/I_min. Reciprocally, for a given bias voltage V_bias, a maximal current I_max corresponds to a minimal resistance R_min = V_bias/I_max. So, with a fixed bias voltage, the range of measurable resistance values is limited by the range of measurable current values. However, if V_bias may vary, then the range of measurable resistance values may be increased without changing the range of measurable current values, as illustrated in the two examples provided hereinafter.

In a first example, let us consider a minimal current I_min flowing through a resistive sensor and a given bias voltage V_bias applied across the resistive sensor, corresponding to a maximal resistance R_max = V_bias/I_min of the resistive sensor. If the bias voltage is increased above V_bias, the current increases too and becomes larger than I_min, therefore allowing the current to decrease further before reaching I_min, and thus making it possible to measure resistance values larger than R_max.

In a second example, let us consider a maximal current I_max flowing through a resistive sensor and a given bias voltage V_bias applied across the resistive sensor, corresponding to a minimal resistance R_min = V_bias/I_max of the resistive sensor. If the bias voltage is decreased below V_bias, the current decreases too and becomes smaller than I_max, therefore allowing the current to increase further before reaching I_max, and thus making it possible to measure resistance values smaller than R_min.

So, by adjusting a bias voltage applied across a resistive sensor, an apparatus according to the invention can measure a wider range of resistance values of the resistive sensor than with a fixed bias voltage, for a given range of measurable current values. The adjustment of the bias voltage does not necessarily imply a modification of the bias voltage. If a value of the bias voltage is adequate, said value may be kept unmodified after an adjustment operation.

Additionally, the apparatus according to the invention comprises a sensor selection unit for selecting a resistive sensor in a plurality of resistive sensors. The apparatus according to the invention may therefore be used to determine a resistance value of a resistive sensor selected in a plurality of resistive sensors.

Advantageously, the bias voltage applied to a resistive sensor may be chosen in such a way as to reduce the current flowing through the resistive sensor for a given resistance value of the resistive sensor. This may reduce the energy consumption of an apparatus according to the invention when determining a resistance value of the resistive sensor. Indeed, the current flowing through the resistive sensor may be copied several times within the apparatus, therefore causing the energy consumption of the apparatus to be at least partly proportional to the intensity of said current. So, reducing a sensing current flowing through a resistive sensor in response to the application of a reduced bias voltage across the resistive sensor may reduce the energy consumption of an apparatus according to the invention.

Preferably, the apparatus according to the invention is implemented as an integrated circuit. Implementing an apparatus according to the invention as an integrated circuit offers several advantages compared to an implementation based on discrete electronic components, such as a lower footprint and a lower energy consumption.

The inventors propose several possible embodiments comprising optional features, where some of them can be combined.

In an embodiment of the invention, the bias voltage controller is able to adjust said bias voltage to keep said sensing current between a low current threshold and a high current threshold. The low current threshold, denoted as I_low, and the high current threshold, denoted as I_high, are respectively the lower bound and the upper bound of a preferred range of current values lying within the range of measurable current values, i.e. lying between a minimal limit value I_min and a maximal limit value I_max, so that $I\_min \leq I\_low < I\_high \leq I\_max$. If the sensing current reaches a threshold (I_low or I_high), the bias voltage may be adjusted in order to bring the sensing current back between the thresholds, i.e. within said preferred range. The preferred range of current values comprised between I_low and I_high may be for instance a range of current values wherein a sensing current may be measured with a limited measurement error and/or a range wherein the maximum sensing current value is limited so as to reduce the energy consumption of an apparatus according to the invention when determining a resistance value of the resistive sensor. Thanks to the adjustment of the bias voltage in such a way as to keep the sensing current within said preferred range, the current measurement unit may be able to provide an accurate measure of the sensing current flowing through the resistive sensor, i.e. a measure with a limited measurement error, and/or to provide such measure with a reduced energy consumption.

In practice, the electrical resistance of a resistive sensor may vary with the bias voltage applied to the sensor. The present invention remains applicable in such case, with the thresholds I_low and I_high being chosen taking into account said variation of the resistance of a resistive sensor with the bias voltage applied to the sensor.

In an embodiment of the invention, the bias voltage controller is configured to apply no bias voltage to said one resistive sensor if the sensing current flowing through said one resistive sensor exceeds an over-current threshold. When no bias voltage is applied to a resistive sensor, no current flows through it and the sensor is thus disabled. So, applying no bias voltage to a resistive sensor may be considered as equivalent to disabling a resistive sensor and *vice versa.* In this embodiment, a resistive sensor may be disabled following the detection of an over-current, i.e. after the sensing current exceeds an over-current threshold. The disabling of a resistive sensor when the sensing current exceeds an over-current threshold may protect the sensor from an over-current that may damage the sensor, which may for instance happen when the electrical resistance of the sensor becomes small, so that the current flowing through the sensor becomes large. The disabling of a resistive sensor when the sensing current exceeds an over-current threshold may also limit the power consumption of the apparatus according to the invention. In other words, the over-current threshold may be chosen as a current value over which the current may damage the sensor, or as a current value over which the power consumption of the apparatus becomes too large, or both.

In an embodiment of the invention, the bias voltage generator comprises:

- a set of units configured for providing a plurality of predetermined voltages;
- a voltage selector configured for selecting a voltage from said plurality based on a command from the bias voltage controller and for applying said voltage to said one resistive sensor.

Having a bias voltage applied to a resistive sensor selected from a plurality of predetermined voltages has several advantages. First, it simplifies the generation of said bias voltage, which can be generated centrally within a single bias voltage generator. Otherwise, in the case of a continuous bias voltage, a dedicated bias voltage generator could be required for each sensor. Second, it simplifies the command from a bias voltage controller for controlling said bias voltage compared to a bias voltage selected from a continuous range of values. In particular, it allows a digital control of the bias voltage generator.

The command from the bias voltage controller for controlling the bias voltage generator may be based on the sensing current in the following manner. If the sensing current lies between a low current threshold I_low and a high current threshold I_high as defined hereinabove, the bias voltage controller sends a command to the voltage selector in order to keep the currently selected bias voltage. If the sensing current falls below the low current threshold I_low, the bias voltage controller sends a command to the voltage selector in order to select a higher bias voltage, if possible, in order to increase the sensing current. If the sensing current rises above the high current threshold I_high, the bias voltage controller sends a command to the voltage selector in order to select a lower bias voltage, if possible, in order to decrease the sensing current. In summary, the command sent by the bias voltage controller to the voltage selector comprised in the bias voltage generator is determined in such a way as to keep the sensing current between the low current threshold I_low and the high current threshold I_high, or to bring the sensing current back within these limit values, if possible.

If the bias voltage cannot be increased above a maximal bias voltage value, or decreased below a minimal bias voltage value, the current measurement unit may still be able to measure the sensing current, provided that such current I remains within the range of measurable current values defined by the minimal limit value I_min and the maximal limit value I_max, i.e. provided that $I\_min \leq I \leq I\_max$.

Preferably, the predetermined voltages are essentially in geometric progression with a common ratio of 1/2. A sequence of values is in geometric progression when each value in the sequence after the first value may be obtained by multiplying the previous value in the sequence by a fixed, non-zero number called a common ratio. For instance, the sequence of values 1, 1/2, 1/4, 1/8, 1/16 is a sequence of values in geometric progression with a common ratio of 1/2. In the context of the present invention, having predetermined voltage values in geometric progression maximizes the range of resistance values that may be measured with the apparatus according to the invention.

Preferably, the low current threshold I_low and the high current threshold I_high are chosen so that the ratio I_high/I_low is equal to 4, in order to keep a stable feedback loop even in case of a variation of the electrical resistance of the resistive sensor with the bias voltage applied to the sensor.

In an embodiment of the invention, the sensor selection unit comprises:

- a first sensor selector coupled with the bias voltage controller and configured for selecting a resistive sensor in the plurality of resistive sensors;
- a second sensor selector coupled with the current measurement unit and configured for selecting another resistive sensor in the plurality of resistive sensors.

The ability of the sensor selection unit to select a sensor for the bias voltage controller, in order to adjust the bias voltage, and to select another sensor for the current measurement unit, in order to measure the sensing current, allows both tasks to be performed in parallel, possibly on different sensors, thus improving the flexibility of the apparatus according to the invention.

In an embodiment of the invention, the bias voltage controller is configured for receiving a copy of the sensing current flowing through said one resistive sensor, and for adjusting the bias voltage applied to said one resistive sensor based on said copy. A current mirror circuit, that is known by one skilled in the art, may be used to provide a copy of the sensing current, preferably when the apparatus according to the invention is implemented as an integrated circuit. Implementing the apparatus according to the invention with an integrated circuit may reduce the footprint and the power consumption of the circuit compared to an implementation based on discrete electronic components. Adjusting the bias voltage based on a copy of the sensing current has the advantage of essentially not perturbing the sensing current flowing through the resistive sensor, hence allowing a reliable measurement of the sensing current and of the resistance of the resistive sensor.

In an embodiment of the invention, the bias voltage generator is configured for adjusting said bias voltage based on a configuration stored in a memory and wherein said configuration is adapted periodically. Adapting the configuration of the bias voltage controller only periodically has the advantage of limiting the power consumption of an apparatus according to the invention. Indeed, adjusting a bias voltage consumes power because a current flowing through the resistive sensor may need to be copied at several places in the apparatus according to the invention. Adjusting the bias voltage only periodically helps to limit the power consumption associated with the adjustment of the bias voltage.

In an embodiment of the invention, the current measurement unit is configured for receiving a copy of the sensing current flowing through said one resistive sensor, and for producing a measure of said sensing current based on said copy. A current mirror circuit, that is known by one skilled in the art, may be used to provide a copy of the sensing current, preferably when the apparatus according to the invention is implemented as an integrated circuit. Implementing the apparatus according to the invention with an integrated circuit may reduce the footprint and the power consumption of the circuit compared to an implementation based on discrete electronic components. Producing a measure of a sensing current based on a copy of the sensing current has the advantage of essentially not perturbing the sensing current flowing through the resistive sensor, hence allowing a reliable measurement of the sensing current and of the resistance of the resistive sensor.

In an embodiment of the invention, the current measurement unit comprises:

- a first subunit able to produce a binary signal based on the sensing current, wherein a period of time of said binary signal is proportional to the intensity of the sensing current;
- a second subunit able to measure said period of time for measuring the intensity of the sensing current.

The conversion of the sensing current, or a copy of the sensing current, into a temporal binary signal by the first subunit of the current measurement unit may be performed by a temporal integration of the current, typically based on a capacitor of capacitance value C, whose terminal voltage V is proportional to the temporal integral of the current I flowing through it according to the following law:

$$V = \int \frac{I}{C} dt \Leftrightarrow I = C \frac{dV}{dt}.$$

Based on said temporal binary signal, wherein a period of time where the binary signal has a high value is proportional to the intensity of the sensing current, the second subunit of the current measurement unit may be able to measure said period of time as a proxy for measuring the intensity of the sensing current. Therefore, in the present embodiment, the current measurement unit is configured to measure a sensing current based on the measurement of a period of time proportional to the intensity of the sensing current. This configuration has the advantage of allowing the current measurement unit to measure a larger range of current values than is typically possible using a classic analog-to-digital (ADC) converter, where the range of measurable current values may be limited by the range of acceptable input current values of the ADC converter.

In an embodiment of the invention, the apparatus according to the invention is configured for determining a resistance value of one of a plurality of chemiresistive gas sensors. The apparatus according to the invention may therefore be used to measure the concentration of a plurality of gases, the concentration of each gas in the plurality being sensed specifically by a chemiresistive gas sensor whose electrical resistance is proportional to the concentration of the gas.

According to a second aspect, the invention provides an electronic device comprising an apparatus according to the invention and implemented as an integrated circuit. Implementing an electronic device comprising an apparatus according to the invention as an integrated circuit offers several advantages compared to an implementation based on discrete electronic components, such as a lower footprint and a lower energy consumption.

According to a third aspect, the invention provides an assembly comprising:

- a plurality of resistive sensors;
- an apparatus according to the invention, and coupled with the plurality of resistive sensors.

In a case where the plurality of resistive sensors comprised in the assembly is a plurality of chemiresistive gas sensors, the assembly may be used to measure the concentration of a plurality of gases, the concentration of each gas in the plurality being sensed specifically by a chemiresistive gas sensor whose electrical resistance is proportional to the concentration of the gas.

According to a fourth aspect, the invention provides a method for operating an apparatus according to the invention for determining a resistance value of one of a plurality of resistive sensors based on a measure of a current responsive to a bias voltage applied to said one resistive sensor, the method comprising the following steps:

a) selecting said one resistive sensor in said plurality of resistive sensors;
b) applying a bias voltage to the selected resistive sensor;
c) adjusting the bias voltage applied to the selected resistive sensor based on a sensing current flowing through the selected resistive sensor;
d) measuring a sensing current flowing through the selected resistive sensor once said bias voltage has been adjusted;
e) determining a resistance value of the selected resistive sensor based on the value of said bias voltage and the measured sensing current.

These steps are preferably, but not necessarily, executed in the indicated order, i.e. the alphabetical order. In step c), the adjustment of the bias voltage does not necessarily imply a modification of the bias voltage. If the value of the bias voltage applied in step b) is adequate, said value may be kept unmodified at step c).

In an embodiment of the invention, the bias voltage applied to the selected resistive sensor is adjusted in order to keep a sensing current flowing through the selected resistive sensor between a low current threshold and a high current threshold. The low current threshold and the high current threshold may be chosen respectively as the lower bound and the upper bound of a preferred range of current values, such a range being for instance a range of current values wherein a sensing current may be measured with a limited measurement error and/or a range wherein the maximum sensing current value is limited, so as to reduce the energy consumption of an apparatus according to the invention when determining a resistance value of the resistive sensor.

In an embodiment of the invention, no bias voltage is applied to the selected resistive sensor if a sensing current flowing through the selected resistive sensor exceeds an over-current threshold. The over-current threshold may be chosen as a current value over which the current may damage the sensor, or as a current value over which the power consumption of the apparatus becomes too large, or both.

In an embodiment of the invention, the bias voltage applied to the selected resistive sensor is adjusted periodically. In this embodiment, the value of the bias voltage applied to a sensor may be determined based on a configuration stored in a memory, said configuration being calibrated once or adjusted periodically, thereby causing the applied bias voltage to be adjusted periodically.

All the possible embodiments and advantages of the first aspect of the invention apply *mutatis mutandis* to other aspects of the invention.

## Brief description of the figures

For a better understanding of the present invention, reference will now be made, by way of example, to the accompanying drawings in which:

- Fig. 1 schematically represents an apparatus according to an embodiment of the invention;
- Fig. 2 illustrates ranges of measurable resistance values of a resistive sensor according to the prior art (Fig. 2a, 2b) and according to the invention (Fig. 2c, 2d);
- Fig. 3 schematically represents a bias voltage generator according to an embodiment of the invention;
- Fig. 4 schematically represents the application of a bias voltage to a resistive sensor and the generation of a sensing current in response to said application;
- Fig. 5 schematically represents a bias voltage controller according to an embodiment of the invention;
- Fig. 6 schematically represents a resistive sensor and a current measurement unit according to an embodiment of the invention;
- Fig. 7 schematically represents a sensor selection unit according to an embodiment of the invention.

The figures are not drawn to scale. Generally, identical or analogous elements are denoted by the same reference numerals or letters in the figures.

## Detailed description of some embodiments of the invention

The present invention will be described with respect to particular embodiments and with reference to certain drawings but the invention is not limited thereto. The described functions are not limited by the described structures. The drawings described are only schematic and are non-limiting. In the drawings, the size of some of the elements may be exaggerated and not drawn to scale for illustrative purposes.

Use of the verb "to comprise", as well as the respective variants and conjugations, does not exclude the presence of elements other than those stated. Use of the article "a", "an" or "the" preceding an element does not exclude the presence of a plurality of such elements.

The terms "first", "second", "third" and the like, in the description and in the claims, are used for distinguishing between similar elements and not necessarily for describing a sequential or chronological order. The terms are interchangeable under appropriate circumstances and the embodiments of the invention can operate in other sequences than described or illustrated herein.

Furthermore, embodiments referred to as "preferred" are to be construed as exemplary manners in which the invention may be implemented rather than as limiting the scope of the invention.

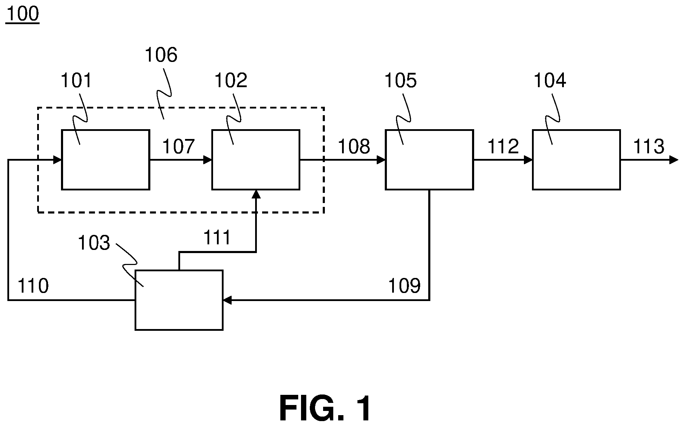

Fig. 1 schematically represents an apparatus 100 according to an embodiment of the invention. Fig. 1 provides a block diagram of the apparatus 100. The apparatus 100 comprises: a bias voltage generator 101 for applying a bias voltage 107 to a resistive sensor 102; a bias voltage controller 103 coupled with the bias voltage generator 101 and configured for adjusting the bias voltage 107 based on a sensing current 108; and a current measurement unit 104 configured for providing a measure 113 of the sensing current 108.

The resistive sensor 102 is part of a plurality of resistive sensors. The bias voltage generator 101 may comprise a plurality of sub-units, each sub-unit being electrically coupled to a resistive sensor in the plurality of resistive sensors, all the sub-units being controlled by the bias voltage controller as illustrated by arrow 110. In Fig. 1, only one resistive sensor in the plurality of resistive sensors is represented as block 102. Block 102, and optionally block 101, comprised in dashed frame 106, may be repeated for each resistive sensor in the plurality, in which case, arrow 107 represents the application by the bias voltage generator, or a sub-unit of the bias voltage generator, of a bias voltage on a resistive sensor in the plurality, and arrow 108 represents a sensing current flowing through said resistive sensor in response to the application of said bias voltage.

The apparatus 100 further comprises a sensor selection unit 105 configured for selecting a resistive sensor 102 in the plurality of resistive sensors and for providing a first copy 109 of the sensing current 108 to the bias voltage controller 103 and a second copy 112 of the sensing current 108 to the current measurement unit 104.

Finally, the bias voltage controller 103 has the ability to prevent the application of a bias voltage to a resistive sensor 102, i.e. disabling a resistive sensor by applying no bias voltage to the resistive sensor, as illustrated by arrow 111, for instance when the current 108 flowing through the resistive sensor 102 exceeds an over-current threshold.

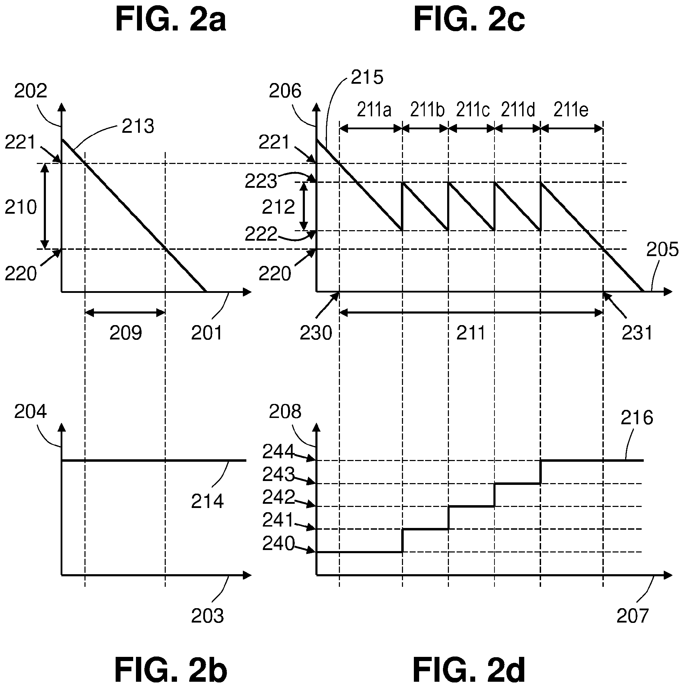

Fig. 2 illustrates ranges 209, 211 of measurable resistance values of a resistive sensor according to the prior art (Figs. 2a, 2b), where a fixed bias voltage is applied to the resistive sensor, and according to the invention (Figs. 2c, 2d), where the bias voltage applied to the resistive sensor may be adjusted.

Fig. 2a is provided with reference axes 201, 202 corresponding respectively to a resistance R of a resistive sensor and a current I flowing to the resistive sensor, both in logarithmic scale. Line 213 represents the relationship between the current I and the resistance R. Fig. 2b is provided with reference axes 203, 204 corresponding respectively to a resistance R of a resistive sensor and a bias voltage V applied to the resistive sensor, both in logarithmic scale. Line 214 represents the relationship between the bias voltage V and the resistance R, which is a constant relationship since the bias voltage V is fixed.

In the case illustrated in Figs. 2a and 2b, with a fixed bias voltage, the range 209 of measurable resistance values is limited by the range 210 of measurable current values, which is determined by a minimal current value 220 and a maximal current value 221. Such minimal and maximal current values 220, 221 may respectively correspond to a minimal and maximal current for a current measurement device.

Similarly to Fig. 2a, Fig. 2c is provided with reference axes 205, 206 corresponding respectively to a resistance R of a resistive sensor and a current I flowing to the resistive sensor, both in logarithmic scale. Line segments 215 represent the relationship between the current I and the resistance R. Similarly to Fig. 2b, Fig. 2d is provided with reference axes 207, 208 corresponding respectively to a resistance R of a resistive sensor and a bias voltage V applied to the resistive sensor, both in logarithmic scale. Line segments 216 represent the relationship between the bias voltage V and the resistance R.

In the case illustrated in Figs. 2c and 2d, the range 211 of measurable resistance values is larger than the corresponding range 209 in Figs. 2a and 2b because the bias voltage may be adjusted, thereby extending the range of measurable resistance values for the same range 210 of measurable current values. In this case, the bias voltage is adjusted so as to keep the current within a preferred range 212 delimited by a low current threshold 222 and a high current threshold 223. The range 211 may be divided into sub-ranges 211a, 211b, 211c, 211d, 211e, each sub-range corresponding to a fixed value of the bias voltage, respectively 240, 241, 242, 243, 244. For a resistance value 230 at the lower end of the range 211, the bias voltage is set to a low value 240, corresponding to the maximal current value 221. As illustrated in Fig. 2c, when the resistance increases, the current decreases according to Ohm's Law (I = V/R). When the current reaches the low current threshold 222, the bias voltage is increased to the value 241, thereby allowing the current to remain within the preferred range 212. When the resistance further increases, the bias voltage is further increased accordingly, until it reaches value 244 above which it cannot be further increased. The range 211 of measurable resistance values extends until resistance value 231, corresponding to a current reaching the minimal current value 220 in the range 210 of measurable current values. Thanks to the adjustment of the bias voltage according to the invention, the range 211 of measurable resistance values is increased compared to the range 209, corresponding to a fixed value of the bias voltage. So, by adjusting a bias voltage applied across a resistive sensor, an apparatus according to the invention can measure a wider range of resistance values of the resistive sensor than with a fixed bias voltage, for a given range of measurable current values.

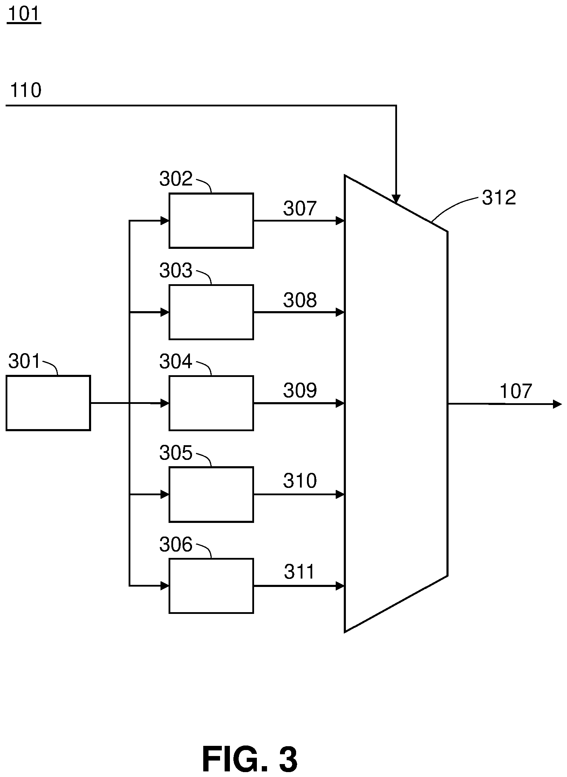

Fig. 3 schematically represents a bias voltage generator 101 according to an embodiment of the invention. The bias voltage generator 101 comprises a reference voltage unit 301, a set of voltage scaling units 302-306, and a voltage selector 312. The set of voltage scaling units 302-306 comprises a first voltage scaling unit 302, a second voltage scaling unit 303, a third voltage scaling unit 304, a fourth voltage scaling unit 305, and a fifth voltage scaling unit 306. The set of voltage scaling units 302-306 may be implemented as a voltage divider. The voltage selector 312 may be implemented as a multiplexer, for instance an analog multiplexer.

The bias voltage generator 101 basically operates as follows. The reference voltage unit 301 provides the set of voltage scaling units 302-306 with a reference voltage. Each voltage scaling unit 302-306 scales the reference voltage by a scaling factor, thereby providing the voltage selector 312 with a plurality of scaled voltage values 307-311. Scaling factors for voltage scaling units 302-306 may respectively be values 1, 1/2, 1/4, 1/8, and 1/16, in which case the scaled voltage values 307-311 are in geometric progression with a common ratio of 1/2. The voltage selector 312 selects a scaled voltage value from the plurality of scaled voltage values 307-311 based on a command 110 received from a bias voltage controller, for instance the bias voltage controller 103 of Fig. 1. The selected scaled voltage 107 corresponds to a bias voltage applied to a resistive sensor, for instance the resistive sensor 102 of Fig. 1.

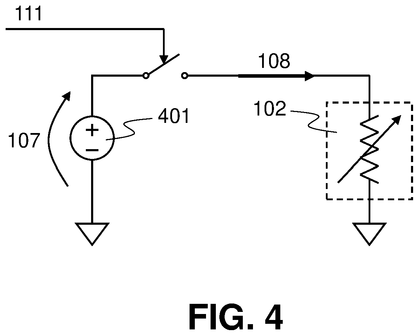

Fig. 4 schematically represents the application of a bias voltage 107 to a resistive sensor 102 and the generation of a sensing current 108 in response to said application. The voltage source 401 generates a bias voltage 107 and may correspond to a bias voltage generator 101 as illustrated in Fig. 1 and Fig. 3. The bias voltage 107 is conditionally applied to the resistive sensor 108 depending on a command 111. The command 111 makes it possible to apply no bias voltage to the resistive sensor 108, i.e. disabling the resistive sensor 108, for instance when the sensing current 108 exceeds an overcurrent threshold.

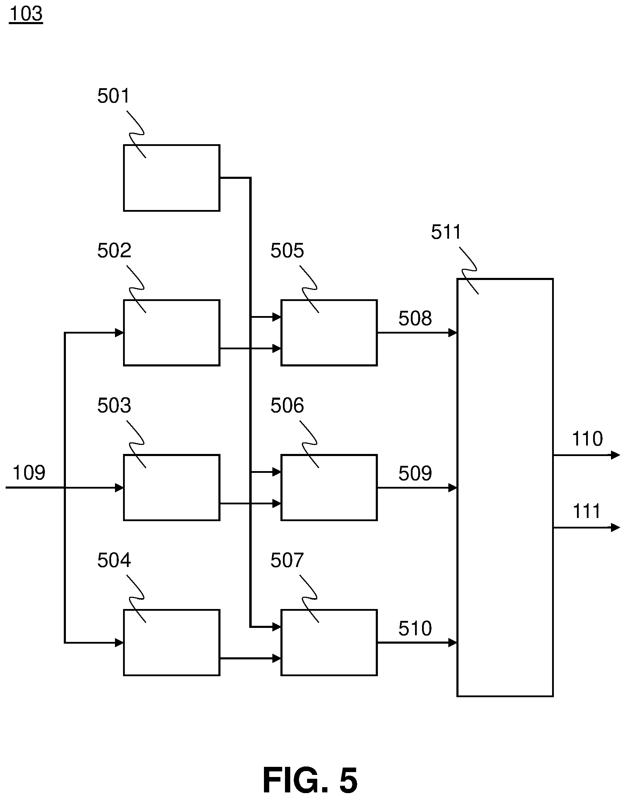

Fig. 5 schematically represents a bias voltage controller 103 according to an embodiment of the invention. The bias voltage controller 103 comprises a reference voltage unit 501, a set of current scaling and conversion units 502-504, a set of voltage comparators 505-507, and a decision unit 511. The set of current scaling and conversion units 502-504 comprises a first current scaling and conversion unit 502, a second current scaling and conversion unit 503, and a third current scaling and conversion unit 504. The set of voltage comparators 505-507 comprises a first voltage comparator 505, a second voltage comparator 506, and a third voltage comparator 507.

The bias voltage controller 103 basically operates as follows. The current scaling and conversion units 502-504 are provided with a copy 109 of a sensing current flowing through a resistive sensor. Each current scaling and conversion unit 502-504 may be provided with its own copy of the sensing current. Each current scaling and conversion unit 502-504 scales its input current value by a scaling factor, and then converts the scaled current value to a voltage value, thereby providing each voltage comparator 505-507 with a converted voltage. In addition, the reference voltage unit 501 provides each voltage comparator 505-507 with a reference voltage. Each voltage comparator 505-507 then compares its converted voltage with the reference voltage in order to determine if a sensing current 108 flowing through a resistive sensor 102 reaches a low current threshold, a high current threshold, and an over-current threshold, respectively. Scaling factors of the current scaling and conversion unit 502-504 are determined in such a way as to allow the voltage comparators 505-507 to detect a low current threshold, a high current threshold, and an over-current threshold, respectively. Each current scaling and conversion unit 502-504 may be implemented based on a current divider. The first voltage comparator 505 provides the decision unit 511 with a "low current" trigger 508 when it detects that the sensing current 108 reaches a low current threshold. The second voltage comparator 506 provides the decision unit 511 with a "high current" trigger 509 when it detects that the sensing current 108 reaches a high current threshold. The third voltage comparator 507 provides the decision unit 511 with an "over-current" trigger 510 when it detects that the sensing current 108 reaches an over-current threshold. Based on the triggers 508-510, the decision unit 511 produces a command 110 to adjust the bias voltage applied to the resistive sensor, so as to keep the sensing current 108 between the low current threshold and the high current threshold, or to bring the sensing current back between these thresholds, if possible. In addition, based on the triggers 508-510, the decision unit 511 may also produce a command 111 to apply no bias voltage to the resistive sensor, i.e. to disable the resistive sensor, for instance when the sensing current 108 exceeds the over-current threshold.

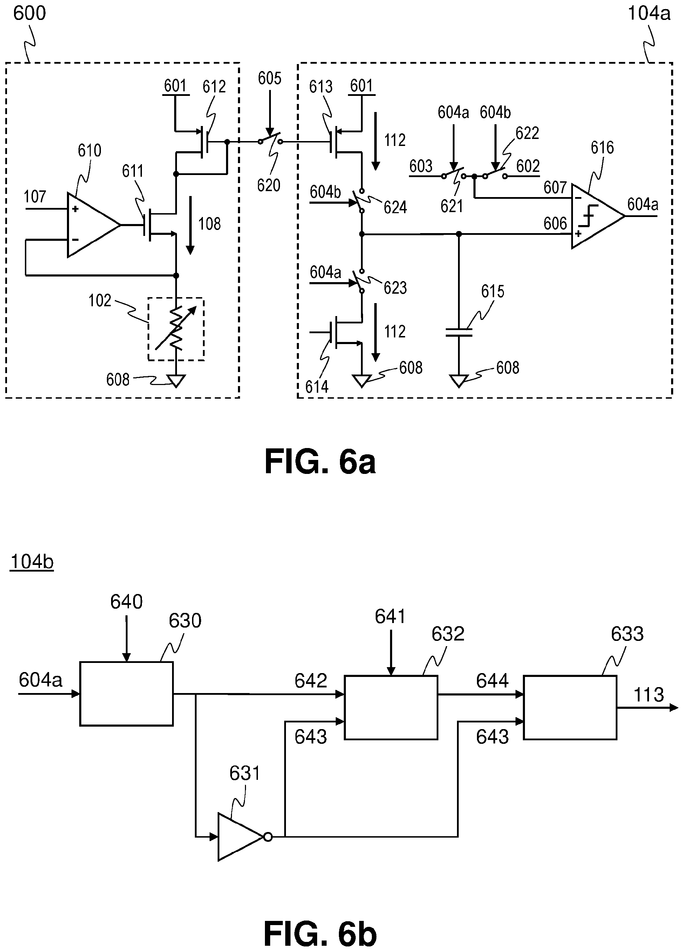

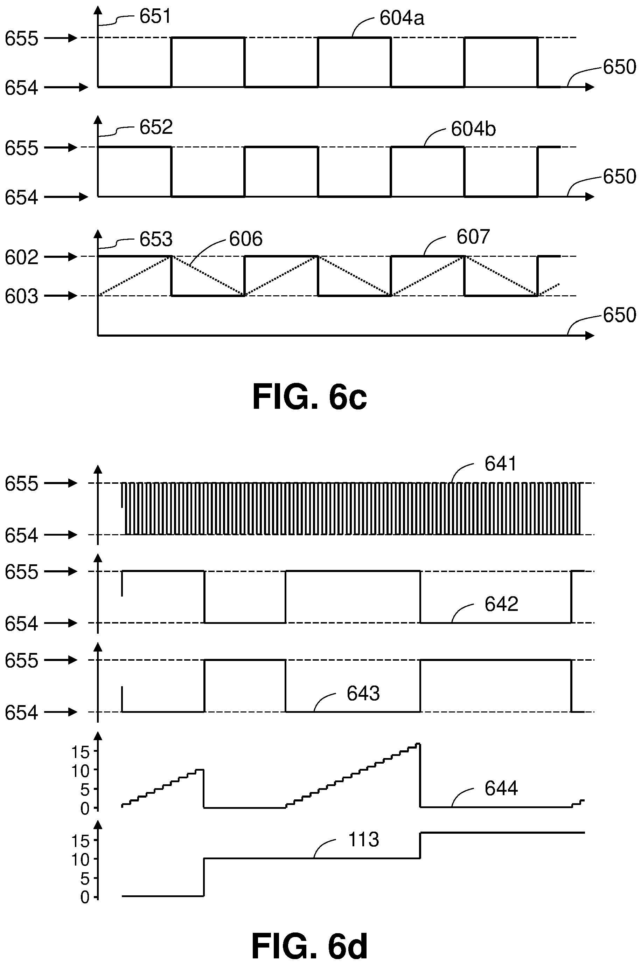

Fig. 6 schematically represents a resistive sensor 102 and a current measurement unit 104 according to an embodiment of the invention. The current measurement unit 104 represented in Fig. 6 comprises a first subunit 104a represented in Fig. 6a and a second subunit 104b represented in Fig. 6b. Fig. 6c schematically represents a timing diagram of some signals of the first subunit 104a. Fig. 6d schematically represents a timing diagram of some signals of the second subunit 104b.

Fig. 6a represents an assembly 600 comprising a resistive sensor 102 and a circuitry able to apply a bias voltage 107 to the resistive sensor 102 in order to produce a sensing current 108. The circuitry comprises an amplifier 610 configured as a voltage follower, a first transistor 611, a second transistor 612, and a ground terminal 608. A non-inverting input terminal of the amplifier 610 is configured to receive a bias voltage 107. A supply voltage 601 powers the circuitry.

In this embodiment, it is assumed that the assembly 600 is duplicated for each resistive sensor 102 in the plurality of resistive sensors. A switch 620 is controlled by a signal 605 and selects a single assembly 600 for measuring the sensing current 108 thereof in a current measurement unit 104 comprising a first subunit 104a and a second subunit 104b. The first subunit 104a produces a binary signal based on the sensing current 108, a period of time of said binary signal being proportional to the intensity of the sensing current 108, such period of time being for example a period of time where the binary signal has a high value. The second subunit 104b measures said period of time for measuring the intensity of the sensing current 108.

The first subunit 104a comprises a third transistor 613, a fourth transistor 614, a capacitor 615, and a comparator 616 able to provide a binary signal 604a, such signal 604a having a low value and a high value. The binary signal 604a may be interpreted as a digital signal, with the low value corresponding to a logic "zero", or "false", and the high value corresponding to a logic "one", or "true". The capacitor 615 has for instance a capacitance of 50pF. The first subunit 104a further comprises ground terminals 608. It is assumed that all ground terminals 608 in the assembly 600 and the first subunit 104a are electrically coupled together.

Signal 604a commands switches 621 and 623, as represented in Fig. 6a. Signal 604b is a binary signal having a low value and a high value. Similarly to signal 604a, the binary signal 604b may also be interpreted as a digital signal, with the low value corresponding to a logic "zero", or "false", and the high value corresponding to a logic "one", or "true". Signal 604b is the logical inverse of the signal 604a, i.e. when signal 604a has a low value, signal 604b has a high value, and vice versa. For instance, signal 604b may be generated from signal 604a using a logical inverter. Signal 604b commands switches 622 and 624, as represented in Fig. 6a. For the command of switches as represented in Fig. 6a, it is assumed that a switch is closed when its control signal has a high value, and open otherwise. Therefore, when switches 621, 623 controlled by signal 604a are closed, switches 622, 624 controlled by signal 604b are open, and vice versa.

Transistors 612 and 613 are configured as a current mirror able to copy the sensing current 108 from the assembly 600 to the first subunit 104a as current 112. Similarly, current 108 may also be copied by transistor 614 as current 112.

The first subunit comprises reference voltages 602 and 603, wherein reference voltage 602 has a higher value than reference voltage 603. For instance, reference voltage 602 may have a value of 1V, and reference voltage 603 may have a value of 0.5V. Signal 604a is the voltage between the output terminal of the comparator 616 and the ground 608. Signal 606 is the voltage between the non-inverting input terminal of the comparator 616 and the ground 608. Signal 607 is the voltage difference between the inverting input terminal of the comparator 616 and the ground 608. Comparator 616 compares signal 606 against signal 607, signal 607 therefore acting as a threshold of the comparator 616.

The first subunit 104a operates in cycles as follows. Assuming signal 604a starts with a low value, signal 604b has a high value, and thus switches 621 and 623 are open whereas switches 622 and 624 are closed. In this case, threshold 607 corresponds to reference voltage 602, the capacitor 615 charges and voltage 606 increases until reaching threshold 607. When voltage 606 reaches threshold 607, the comparator 616 switches the polarity of signal 604a from a low value to a high value, thereby closing switches 621 and 623, and opening switches 622 and 624. In this case, threshold 607 corresponds to reference voltage 603, the capacitor 615 discharges, and voltage 606 decreases until reaching threshold 607. When voltage 606 reaches threshold 607, the comparator 616 switches the polarity of signal 604a from a high value to a low value, and a new cycle begins. In summary, voltage 606 is a triangle signal that is converted into a binary signal 604a of the same period, said period being proportional to the intensity of the current 112, which is a copy of sensing current 108.

Fig. 6c schematically represents a timing diagram of some signals of the first subunit 104a. Fig. 6c is provided with reference axes 650, 651, 652, and 653. Axis 650 represents time. Axis 651 represents the amplitude of signal 604a, which is a binary signal with a low value 654 and a high value 655. Similarly, axis 652 represents the amplitude of signal 604b, which is a binary signal with a low value 654 and a high value 655, signal 604b being the logical inverse of signal 604a as detailed hereinabove. Axis 653 represents the amplitude of signal 606 as dotted lines, and signal 607 as solid lines, with reference voltages 602 and 603 being represented as horizontal dashed lines.

In this embodiment, the first subunit 104a is an analog subunit that provides a digital signal 604a to the second, digital subunit 104b, a period of time of said digital signal 604a being proportional to the intensity of the sensing current 108, 112. In turn, the second subunit 104b measures said period of time for measuring the intensity of the sensing current 108, 112.

Fig. 6b schematically represents the second subunit 104b. The second subunit 104b comprises a frequency divider 630, a logical inverter 631, a digital counter 632, and a register 633. The second subunit 104b is provided with the following signals: a binary signal 604a from the first subunit 104a; a frequency division factor 640; and a digital clock signal 641.

The second subunit 104b basically operates as follows. The frequency divider 630 receives the binary signal 604a and divides its frequency based on the frequency division factor 640 to produce a frequency-divided binary signal 642. The frequency-divided binary signal 642 is logically inverted by the logical inverter 631 to produce an inverted binary signal 643. An "enable" input terminal of the digital counter 632 is provided with the frequency-divided binary signal 642, and a "reset" input terminal of the digital counter 632 is provided with the inverted binary signal 643. The digital counter 632 is further provided with the digital clock signal 641. The digital counter 632 increments a count value on a rising edge of the digital clock signal 641 provided that its "enable" input terminal is asserted, i.e. receives a high digital value, i.e. a logic "one" or "true", and that its "reset" input terminal is not asserted, i.e. receives a low digital value, i.e. a logic "zero" or "false". When the "enable" input terminal of the digital counter 632 is not asserted, the count value is not incremented on a rising edge of the digital clock signal 641. When the "reset" input terminal of the digital counter 632 is asserted, the count value is reset to a default value, for instance zero. The count value of the digital counter 632 is provided at its output terminal as signal 644, which is in turn provided to an input terminal of the register 633. A "clock" input terminal of the register 633 is provided with the inverted binary signal 643. The register 633 captures the value of the signal 644 representing the count value of the digital counter 632 on a rising edge of the inverted binary signal 643, i.e. when said signal 643 transitions from a low to a high digital value. The captured value of the signal 644 is provided at an output terminal of the register 633 as an output signal 113.

Fig. 6d schematically represents a timing diagram of some signals of the second subunit 104a. The digital clock signal 641, the frequency-divided binary signal 642, and the inverted binary signal 643 are digital binary signals with a low value 654 and a high value 655. Signal 644 represents the count value of the digital counter 632 and is incremented on a rising edge of the digital clock signal 641 provided that its "enable" input terminal driven by signal 642 is asserted and that its "reset" input terminal driven by signal 643 is not asserted. The value of the signal 644 is captured by the register 633 on a rising edge of the inverted binary signal 643. The captured value of the signal 644 is provided at an output terminal of the register 633 as an output signal 113.

The output signal 113 may be interpreted as a measure of the period of time of the binary signal 604a, and therefore as a measure of the intensity of the sensing current 108, 112. Based on the measure I of the sensing current 108, 112 and the value V of the bias voltage 107 applied to the resistive sensor 102, the resistance value R of the resistive sensor 102 may be determined using Ohm's Law as R = V/I.

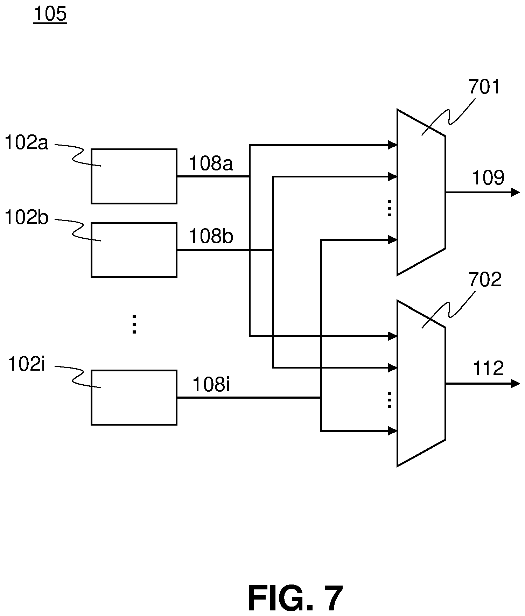

Fig. 7 schematically represents a sensor selection unit 105 according to an embodiment of the invention. The sensor selection unit 105 comprises a first sensor selector 701 that may be coupled with a bias voltage controller, such as the bias voltage controller 103, and a second sensor selector 702 that may be coupled with a current measurement unit, such a the current measurement unit 104. The first sensor selector 701 and the second sensor selector 702 may each be implemented as a multiplexer.

The sensor selection unit 105 basically operates as follows. Each sensor selector 701, 702 receives a plurality of currents 108a, 108b, 108i from a plurality of resistive sensors 102a, 102b, 102i. Each current 108a, 108b, 108i may be a copy of a sensing current flowing in a resistive sensor 102a, 102b, 102i. The first sensor selector 701 selects a current from the plurality and provides it to the bias voltage controller as current 109. Similarly, the second sensor selector 702 selects a current from the plurality, that may be a different current from the one selected by the first sensor selector 701, and provides it to the current measurement unit as current 112. Note that the pluralities of currents 108a, 108b, 108i and resistive sensors 102a, 102b, 102i are shown for illustrative purpose only. Namely, a different number of currents and/or resistive sensors in respective pluralities are possible.

In summary, the invention relates to an apparatus for determining a resistance value of one of a plurality of resistive sensors based on a measure of a current responsive to a bias voltage applied to said one resistive sensor, the apparatus comprising: a bias voltage generator for applying a bias voltage to said one resistive sensor; a bias voltage controller coupled with said bias voltage generator and configured for adjusting said bias voltage based on a sensing current flowing through said one resistive sensor; a current measurement unit configured for measuring a sensing current flowing through said one resistive sensor once said bias voltage has been adjusted; a sensor selection unit coupled with the bias voltage controller and the current measurement unit, and configured for selecting a resistive sensor in the plurality of resistive sensors.

Although the present invention has been described above with respect to particular embodiments, it will readily be appreciated by a person skilled in the art that the present disclosure is not limited by what has been particularly shown and/or described and that alternatives or modified embodiments could be developed in the light of the overall teaching of this disclosure.

## Claims

1. Apparatus (100) for determining a resistance value of one (102) of a plurality of resistive sensors based on a measure of a current responsive to a bias voltage (107) applied to said one resistive sensor (102), the apparatus (100) comprising:

   - a bias voltage generator (101) for applying a bias voltage (107) to said one resistive sensor (102);
   - a bias voltage controller (103) coupled with said bias voltage generator (101) and configured for adjusting said bias voltage (107) based on a sensing current (108, 109) flowing through said one resistive sensor (102);
   - a current measurement unit (104) configured for measuring a sensing current (108, 112) flowing through said one resistive sensor (102) once said bias voltage (107) has been adjusted;
   - a sensor selection unit (105) coupled with the bias voltage controller (103) and the current measurement unit (104), and configured for selecting a resistive sensor (102) in the plurality of resistive sensors.

2. Apparatus (100) according to the preceding claim, wherein the bias voltage controller (103) is able to adjust said bias voltage (107) to keep said sensing current (108, 109) between a low current threshold (222) and a high current threshold (223).

3. Apparatus (100) according to any of the preceding claims, wherein the bias voltage controller (103) is configured to apply no bias voltage to said one resistive sensor (102) if the sensing current (108, 109) flowing through said one resistive sensor (102) exceeds an over-current threshold.

4. Apparatus (100) according to any of the preceding claims, wherein the bias voltage generator (101) comprises:

   - a set of units (302-306) configured for providing a plurality of predetermined voltages (307-311);
   - a voltage selector configured for selecting a voltage (107) from said plurality (307-311) based on a command (110) from the bias voltage controller (103) and for applying said voltage (107) to said one resistive sensor (102).

5. Apparatus (100) according to the preceding claim, wherein the predetermined voltages (307-311) are essentially in geometric progression with a common ratio of 1/2.

6. Apparatus (100) according to any of the preceding claims, wherein the sensor selection unit (105) comprises:

   - a first sensor selector (701) coupled with the bias voltage controller (103) and configured for selecting a resistive sensor (102) in the plurality of resistive sensors (102a, 102b, 102i);
   - a second sensor selector (702) coupled with the current measurement unit (104) and configured for selecting another resistive sensor in the plurality of resistive sensors (102a, 102b, 102i).

7. Apparatus (100) according to any of the preceding claims, wherein the bias voltage controller (103) is configured for receiving a copy of the sensing current (108, 109) flowing through said one resistive sensor (102), and for adjusting the bias voltage (107) applied to said one resistive sensor (102) based on said copy.

8. Apparatus (100) according to any of the preceding claims, wherein the bias voltage generator (101) is configured for adjusting said bias voltage (107) based on a configuration stored in a memory and wherein said configuration is adapted periodically.

9. Apparatus (100) according to any of the preceding claims, wherein the current measurement unit (104) is configured for receiving a copy of the sensing current (108, 112) flowing through said one resistive sensor (102), and for producing a measure (113) of said sensing current (108, 112) based on said copy.

10. Apparatus (100) according to any of the preceding claims, wherein the current measurement unit (104) comprises:

- a first subunit (104a) able to produce a binary signal (604a) based on the sensing current (108, 112), wherein a period of time of said binary signal (604a) is proportional to the intensity of the sensing current (108, 112);
- a second subunit (104b) able to measure said period of time for measuring the intensity of the sensing current (108, 112).

11. Apparatus (100) according to any of the preceding claims, and configured for determining a resistance value of one of a plurality of chemiresistive gas sensors.

12. Assembly comprising:

- a plurality of resistive sensors;
- an apparatus (100) according to any of claims 1 to 11, and coupled with the plurality of resistive sensors.

13. Method for operating an apparatus (100) according to any of claims 1 to 11 for determining a resistance value of one of a plurality of resistive sensors based on a measure of a current responsive to a bias voltage (107) applied to said one resistive sensor (102), the method comprising the following steps:

a) selecting said one resistive sensor (102) in said plurality of resistive sensors;
b) applying a bias voltage (107) to the selected resistive sensor (102);
c) adjusting the bias voltage (107) applied to the selected resistive sensor (102) based on a sensing current (108, 109) flowing through the selected resistive sensor (102);
d) measuring a sensing current (108, 112) flowing through the selected resistive sensor (102) once said bias voltage (107) has been adjusted;
e) determining a resistance value of the selected resistive sensor (102) based on the value of said bias voltage (107) and the measured sensing current (113).

14. Method according to the preceding claim, wherein the bias voltage (107) applied to the selected resistive sensor (102) is adjusted in order to keep a sensing current (108) flowing through the selected resistive sensor (102) between a low current threshold and a high current threshold.

15. Method according to any of the two preceding claims, wherein the bias voltage (107) applied to the selected resistive sensor (102) is adjusted periodically.

**FIG. 1**

# FIG. 2a

# FIG. 2c

# FIG. 2b

# FIG. 2d

<u>101</u>

<u>110</u>

302

301

303

307

304

308

305

309

306

310

311

312

107

**FIG. 3**

111

108

107

401

102

**FIG. 4**

103

501

502

503

109

504

505

508

506

509

507

510

511

110

111

FIG. 5

FIG. 6a

FIG. 6b

**FIG. 6c**

**FIG. 6d**

**FIG. 7**

Europäisches Patentamt
European Patent Office
Office européen des brevets

# EUROPEAN SEARCH REPORT

**Application Number**

EP 24 18 5993

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/132017 A1 (KIM JAE JOON [KR] ET AL) 6 May 2021 (2021-05-06) <br> * paragraphs [0046], [0047], [0050], [0051], [0053] - [0055] * <br> * claims 1,2,6 * <br> * figure 1 * | 1-15 | INV. <br> G01N27/04 <br> G01R27/14 |
| A | PUYOL RAFAEL ET AL: "An Ultra-Low-Power Read-Out Circuit for Interfacing Novel Gas Sensors Matrices", <br> IEEE SENSORS JOURNAL, IEEE, USA, <br> vol. 22, no. 10, 7 April 2022 (2022-04-07) <br> , pages 9521-9533, XP011908315, <br> ISSN: 1530-437X, DOI: <br> 10.1109/JSEN.2022.3165755 <br> [retrieved on 2022-04-07] <br> * paragraphs [0III] - [000A], [0III] - [000B], [0III] - [000G] * <br> * figures 4,13 * | 1-15 | |
| A | GRASSI M ET AL: "A high-precision wide-range front-end for resistive gas sensors arrays", <br> SENSORS AND ACTUATORS B: CHEMICAL, <br> ELSEVIER BV, NL, <br> vol. 111-112, <br> 11 November 2005 (2005-11-11), pages 281-285, XP025329045, <br> ISSN: 0925-4005, DOI: <br> 10.1016/J.SNB.2005.03.103 <br> [retrieved on 2005-11-11] <br> * paragraphs [0002], [0003] * <br> * figures 1,3 * | 1-15 | **TECHNICAL FIELDS SEARCHED (IPC)** <br><br> G01N <br> G01R |

-/--

The present search report has been drawn up for all claims

| Place of search | Date of completion of the search | Examiner |
|---|---|---|
| Munich | 17 December 2024 | Stussi, Elisa |

page 1 of 2

Europäisches
Patentamt

European
Patent Office

Office européen
des brevets

## EUROPEAN SEARCH REPORT

**Application Number**

EP 24 18 5993

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GRASSI M ET AL: "A 141-dB Dynamic Range CMOS Gas-Sensor Interface Circuit Without Calibration With 16-Bit Digital Output Word", IEEE JOURNAL OF SOLID-STATE CIRCUITS, IEEE, USA, vol. 42, no. 7, 1 July 2007 (2007-07-01), pages 1543-1554, XP011186320, ISSN: 0018-9200, DOI: 10.1109/JSSC.2007.899087 * paragraph [0III] * * figures 4-6 *  ----- | 1-15 | |
| | | | **TECHNICAL FIELDS SEARCHED (IPC)** |

The present search report has been drawn up for all claims

| Place of search | Date of completion of the search | Examiner |
|---|---|---|
| Munich | 17 December 2024 | Stussi, Elisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................
& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 24 18 5993

17-12-2024

| Patent document cited in search report | Publication date | Patent family member(s) | Publication date |
|---|---|---|---|
| US 2021132017 A1 | 06-05-2021 | KR 20180084458 A | 25-07-2018 |
| | | US 2021132017 A1 | 06-05-2021 |
| | | WO 2018135711 A1 | 26-07-2018 |

EPO FORM P0459

For more details about this annex : see Official Journal of the European Patent Office, No. 12/82

**EP 4 675 266 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 08247993 A